# EUROPÄISCHE PATENTSCHRIFT

(11) **EP 3 699 328 B1**
(45) Veröffentlichungstag und Bekanntmachung des Hinweises auf die Patenterteilung: **29.11.2023**
(21) Anmeldenummer: 19158315.2
(22) Anmeldetag: 20.02.2019
(51) Int. Cl.: C30B 23/06, C30B 29/36

(54) **HERSTELLUNGSVERFAHREN FÜR EINEN SIC-VOLUMENEINKRISTALL UND ZÜCHTUNGSANORDNUNG DAFÜR**
MANUFACTURING METHOD FOR SIC-VOLUME SINGLE CRYSTAL AND GROWTH ASSEMBLY FOR SAME
PROCÉDÉ DE FABRICATION POUR UN MONOCRISTAL VOLUMIQUE DE SIC ET DISPOSITIF DE CROISSANCE CORRESPONDANT

(43) Veröffentlichungstag der Anmeldung: 26.08.2020
(73) Patentinhaber: SiCrystal GmbH, 90411 Nürnberg (DE)
(72) Erfinder: Ecker, Bernhard, 90411 Nürnberg (DE); Müller, Ralf, 90411 Nürnberg (DE); Stockmeier, Matthias, 90411 Nürnberg (DE); Vogel, Michael, 90411 Nürnberg (DE); Weber, Arnd-Dietrich, 90411 Nürnberg (DE)
(74) Vertreter: Rau, Schneck & Hübner Patentanwälte Rechtsanwälte PartGmbB

(56) Entgegenhaltungen:
- CN-A- 107 779 955
- CN-A- 108 130 593
- JP-A- 2008 110 907
- US-A1- 2010 175 614
- France Mersen ET AL: "A WORLD EXPERT in materials and solutions for high temperature processes Contact for Europe Contact for Asia Contact for Europe A GLOBAL PLAYER St", , 9. Juli 2016 (2016-07-09), XP055609540, Gefunden im Internet: URL:https://www.graphite-eng.com/uploads/d ownloads/calcarb_brochure.pdf [gefunden am 2019-07-29]

## Beschreibung

Die Erfindung betrifft ein Verfahren zur Herstellung mindestens eines SiC-Volumeneinkristalls mittels Sublimationszüchtung sowie eine Züchtungsanordnung zur Herstellung eines SiC-Volumeneinkristalls.

Das Halbleitermaterial Siliziumcarbid (SiC) wird aufgrund seiner herausragenden physikalischen, chemischen, elektrischen und optischen Eigenschaften unter anderem auch als Ausgangsmaterial für leistungselektronische Halbleiterbauelemente, für Hochfrequenzbauelemente und für spezielle lichtgebende Halbleiterbauelemente eingesetzt. Für diese Bauelemente werden SiC-Substrate (= SiC-Wafer) mit möglichst großem Substratdurchmesser und möglichst hoher Qualität benötigt.

Basis für die SiC-Substrate sind hochwertige SiC-Volumeneinkristalle, die in der Regel mittels physikalischer Gasphasenabscheidung (PVT) hergestellt werden, insbesondere mittels eines z.B. in der US 8,865,324 B2 beschriebenen (Sublimations-)Verfahrens. Aus diesen SiC-Volumeneinkristallen werden scheibenförmige einkristalline SiC-Substrate herausgeschnitten, die nach einer mehrstufigen Bearbeitung ihrer Oberfläche, insbesondere mittels mehrerer Polierschritte, im Rahmen der Bauelementefertigung mit mindestens einer einkristallinen Epitaxieschicht z.B. aus SiC oder GaN (Galliumnitrid) versehen werden. Die Eigenschaften dieser Epitaxieschicht und damit letztlich auch die der daraus hergestellten Bauelemente hängen entscheidend von der Qualität des SiC-Substrats bzw. des zugrundeliegenden SiC-Volumeneinkristalls ab.

Für eine optimale Ausbeute sollten Kristalldefekte (wie z.B. Randdefekte = Modifikationsstörungen, lokale Versetzungserhöhungen usw.), die während des Kristallwachstums durch Abweichungen von der idealen Kristallform entstehen können, weitestgehend vermieden werden. Weiterhin ist die Herstellung von SiC-Volumeneinkristallen durch den PVT-Prozess sehr kosten- und zeitintensiv. Material, das z.B. durch eine thermisch bedingte asymmetrische Kristallstruktur für die Weiterverwendung zur Bauelementeherstellung unbrauchbar ist, führt deshalb zu stark verringerten Ausbeuten und erhöhten Kosten.

Bei der Herstellung von SiC-Volumeneinkristallen wird üblicherweise ein Züchtungstiegel aus Graphit oder einem Refraktär-Metall mittels einer Induktions- oder einer Widerstandsheizung aufgeheizt. Im Inneren des Züchtungstiegels wird SiC-Quellmaterial sublimiert und auf einem SiC-Keimkristall abgeschieden. Wegen der Rotationssymmetrie des so gezüchteten SiC-Volumeneinkristalls kommen rotationssymmetrische Züchtungsanordnungen zum Einsatz.

Es gibt jedoch vielfältige Einflussgrößen, die sich auf eine Abweichung des thermischen Feldes und damit auf die Abweichung der Kristallgeometrie von der idealen Rotationssymmetrie auswirken. So kann beispielsweise die eingesetzte Heizung nicht ideal rotationssymmetrisch ausgeführt sein. Insbesondere können elektrische Anschlüsse, Halterungen und dergleichen zu geringfügigen Abweichungen von der Rotationssymmetrie führen.

In der CN 105442038 A und der CN 105568370 A werden jeweils Herstellungsverfahren und Züchtungsanordnungen beschrieben, bei denen der Züchtungstiegel während der Kristallzüchtung kontinuierlich innerhalb der Heizeinheit und der thermischen Isolation gedreht wird. So lassen sich Einflüsse auf den aufwachsenden SiC-Volumeneinkristall, die aus der nicht perfekten Rotationssymmetrie der Heizeinheit herrühren, im Lauf der Züchtungszeit herausmitteln. Allerdings können Erschütterungen, die durch die Drehbewegung des Züchtungstiegels hervorgerufen werden, zu Kristalldefekten, wie z.B. zu Kohlenstoffeinschlüssen aus dem Wandmaterial, führen. Weiterhin wirken sich lokale Temperaturschwankungen, die durch die Rotation in einem nicht rotationssymmetrischen Temperaturfeld hervorgerufen werden, negativ auf die Kristallqualität, insbesondere auf die Versetzungsdichte aus.

In der CN 107 779 955 A werden eine Züchtungsanordnung und ein Verfahren zur Herstellung von SiC-Einkristallen beschrieben, wobei die Züchtungsanordnung einen Züchtungstiegel, eine Heizeinrichtung und eine um den Züchtungstiegel angeordnete thermische Isolation aus mehreren konzentrischen Isolationszylindern enthält. Der innerste Isolationszylinder besteht aus einem C/C-Komposit-Material und hat in axialer Richtung verlaufende Längsschlitze. Dieser innerste Isolationszylinder ist radial nach au-ßen gesehen umgeben von einer Innenschichtisolation aus weichem Filz, einer Innenschichtisolation aus hartem Filz, einer Außenschichtisolation aus weichem Filz und einer Außenschichtisolation aus hartem Filz.

In der JP 2008 110 907 A werden eine Züchtungsanordnung und ein Verfahren zur Herstellung SiC-Einkristallen beschrieben, wobei die Züchtungsanordnung einen Züchtungstiegel, eine Heizeinrichtung und eine um den Züchtungstiegel angeordnete Isolation aus zwei bis 100 konzentrischen Isolationszylinder aus Graphit-Filz enthält.

In der CN 108 130 593 A werden eine Züchtungsanordnung und ein Verfahren zur Herstellung von SiC-Einkristallen beschrieben, wobei die Züchtungsanordnung einen Züchtungstiegel eine Heizeinrichtung und eine um den Züchtungstiegel angeordnete thermische Isolation enthält. Letztere setzt sich zusammen aus einer inneren Schicht aus einem ersten Graphit-Kohlenstoff-Filz und einer äußeren Schicht aus einem zweiten Graphit-Kohlenstoff-Filz, wobei zwischen diesen beiden Schichten eine Lage aus Graphit-Papier angeordnet ist.

Die Aufgabe der Erfindung besteht deshalb darin, ein Herstellungsverfahren sowie eine Züchtungsanordnung der eingangs bezeichneten Art so anzugeben, dass damit ein besserer SiC-Volumeneinkristall hergestellt werden kann.

Zur Lösung der das Verfahren betreffenden Aufgabe wird ein Verfahren entsprechend den Merkmalen des Anspruchs 1 angegeben. Bei dem erfindungsgemäßen Verfahren wird vor dem Züchtungsbeginn in mindestens einem Kristallwachstumsbereich eines Züchtungstiegels mindestens ein SiC-Keimkristall angeordnet, und in mindestens einen SiC-Vorratsbereich des Züchtungstiegels insbesondere pulverförmiges SiC-Quellmaterial eingebracht. Während der Züchtung wird mittels Sublimation des SiC-Quellmaterials und mittels Transport der sublimierten gasförmigen Komponenten in den mindestens einen Kristallwachstumsbereich dort eine SiC-Wachstumsgasphase erzeugt, und wächst der mindestens eine eine zentrale Mittenlängsachse aufweisende SiC-Volumeneinkristall mittels Abscheidung aus der SiC-Wachstumsgasphase auf dem mindestens einen SiC-Keimkristall auf. Der Züchtungstiegel wird vor dem Züchtungsbeginn mit einer rotationssymmetrischen und sich axial in Richtung der zentralen Mittenlängsachse erstreckenden insbesondere thermischen Isolation umgeben, die mindestens zwei Isolationsteilzylinder aufweist. Dabei werden die mindestens zwei Isolationsteilzylinder konzentrisch zueinander angeordnet und ineinander gesetzt, und jeder der mindestens zwei Isolationsteilzylinder hat eine in einer radialen Richtung gemessene Wandstärke. Die Isolation wird fiktiv in mehrere axial in Richtung der zentralen Mittenlängsachse hintereinander angeordnete Isolationsringsegmente aufgeteilt. Jedes dieser Isolationsringsegmente wird seinerseits fiktiv in mehrere in einer tangentialen Richtung nebeneinander angeordnete Volumenelemente aufgeteilt, und weist jeweils eine über die Wandstärken aller der mindestens zwei Isolationsteilzylinder gemessene mittlere Isolationsringsegmentdichte auf. Die mindestens zwei Isolationsteilzylinder, die jeweils Dichteabweichungen in Teilbereichen haben, werden so ausgewählt und zueinander platziert, dass jedes Volumenelement des betreffenden Isolationsringsegments eine Volumenelementdichte hat, die um höchstens 10% von der mittleren Isolationsringsegmentdichte des betreffenden Isolationsringsegments abweicht, wobei sich jedes Volumenelement in axialer Richtung über eine axiale Elementlänge, die gleich groß wie eine axiale Segmentlänge des Isolationsringsegments ist und die bis zu 50 mm beträgt, in Umfangsrichtung über eine äußere tangentiale Elementlänge von bis zu 50 mm und in radialer Richtung über die Addition aller Wandstärken der mindestens zwei Isolationsteilzylinder erstreckt.

Hierbei sind alle Richtungen bezogen auf die zentrale Mittenlängsachse zu verstehen. So ist die axiale Richtung insbesondere die Richtung längs der zentralen Mittenlängsachse und die radiale Richtung insbesondere eine beliebige senkrecht zur zentralen Mittenlängsachse orientierte Richtung. Weiterhin ist die Umfangsrichtung (= tangentiale Richtung) insbesondere als diejenige um die zentrale Mittenlängsachse zu verstehen. Die äußere tangentiale Elementlänge der Volumenelemente wird in der radialen Position außen am äußersten Isolationsteilzylinder, also insbesondere an der Au-ßenumfangsfläche des von der zentralen Mittenlängsachse radial am weitesten entfernt positionierten Isolationsteilzylinders, gemessen. Für die äu-ßere tangentiale Elementlänge und auch für die axiale Elementlänge der Volumenelemente liegt die Untergrenze jeweils bei insbesondere 10 mm, wobei bevorzugte Werte jeweils 20 mm, 30 mm, 40 mm oder 50 mm sind.

Vorzugsweise hat jedes Isolationsringsegment einen anderen axialen Abstand vom axial unteren oder oberen Rand der Isolation. Insbesondere sind alle Volumenelemente aller Isolationsringsegmente gleich groß, zumindest im Wesentlichen.

Bei der Ermittlung der mittleren Isolationsringsegmentdichte werden in radialer Richtung, in der die Wandstärken der mindestens zwei Isolationsteilzylinder gemessen werden, insbesondere nur Bereiche erfasst, in denen sich Isolationsmaterial eines der mindestens zwei Isolationsteilzylinder befindet. Dagegen bleiben etwaige Zwischenräume zwischen benachbarten Isolationsteilzylindern vorzugsweise unberücksichtigt. Während der Züchtung befinden sich in einem solchen Zwischenraum aufgrund des niedrigen Züchtungsdrucks von beispielsweise zwischen etwa 1 hPa (= mbar) und etwa 100 hPa (= mbar) ohnehin nur wenige Gasatome. Die außerhalb des Züchtungstiegels herrschende Gasatmosphäre setzt sich z.B. im Wesentlichen aus mindestens einem Edelgas, wie beispielsweise Argon (Ar), und aus Stickstoff (N) zusammen. Diese wenigen Gasatome können bei der Dichtebetrachtung außer Betracht bleiben. Sie sind verglichen mit dem deutlich dichteren Isolationsmaterial der mindestens zwei Isolationsteilzylinder zu vernachlässigen.

Erfindungsgemäß wurde erkannt, dass außer den Komponenten, die den Energieeintrag in die Züchtungsanordnung bestimmen, also insbesondere die Induktionsspule(n) und/oder die Heizelemente einer induktiven Heizeinrichtung bzw. einer Widerstandsheizung, auch die Isolation, die die thermische Energie innerhalb der Züchtungsanordnung hält bzw. die den Energieaustrag aus der Züchtungsanordnung maßgeblich bestimmt, einen wesentlichen Einfluss auf die Rotationssymmetrie des aufwachsenden SiC-Volumeneinkristalls hat. So können z.B. geringfügige lokale Dichteunterschiede der (thermischen) Isolation zu einem unsymmetrischen Wärmeaustrag und damit zu einem nicht ideal rotationssymmetrischen SiC-Volumeneinkristall führen. In dem Temperaturbereich von insbesondere über 2000 °C, in dem SiC-Volumeneinkristalle hergestellt werden, erfolgt der Wärmetransport hauptsächlich durch Strahlung, weshalb die Dichte des Isolationsmaterials der (thermischen) Isolation direkt mit dem Wärmetransport korreliert ist.

Deshalb wird vorteilhafterweise ein rotationssymmetrisches Temperaturfeld durch gezielte Anpassung der Isolationseigenschaften an die vorherrschenden Bedingungen eingestellt, um so mit dem Verfahren möglichst perfekt rotationssymmetrische SiC-Volumeneinkristalle herzustellen.

Aufgrund ihres Herstellungsprozesses weisen (thermische) Isolationen, die bei Verfahren zur Herstellung von SiC-Volumeneinkristallen zum Einsatz kommen, bereits im Auslieferzustand innerhalb der Zylindergeometrie eines Isolationsteilzylinders aber auch von Isolationsteilzylinder zu Isolationsteilzylinder unterschiedliche Materialeigenschaften auf. So kann insbesondere die Dichte der Isolation von Schwankungen betroffen sein. Derartige Materialschwankungen wirken sich direkt auf die Wärmeleitfähigkeit, damit auf die Homogenität der Wärmeabfuhr im Kristallzüchtungsprozess und damit auch auf die Rotationssymmetrie des aufwachsenden SiC-Volumeneinkristalls aus.

Hinzukommt, dass eine (thermische) Isolation aus Kostengründen insbesondere mehrmals für die Herstellung von SiC-Volumeneinkristallen eingesetzt wird. Aufgrund der starken Beanspruchungen durch sehr hohe Temperaturen von über 2000 °C und auch durch die Silizium (Si)-haltige Gasphase ändern sich die Isolationseigenschaften im Lauf der Zeit. So reagieren die Si-haltigen Gasphasenkomponenten, die aus dem Züchtungstiegel austreten mit dem Isolationsmaterial, insbesondere Kohlenstoff, der Isolation zu SiC, das in die Isolation eingelagert wird und sich damit auf die Isolationseigenschaften auswirkt. Insbesondere wird durch das eingelagerte SiC die Dichte des Isolationsmaterials lokal erhöht, wodurch die thermische Isolationswirkung an dieser Stelle sinkt und der Züchtungstiegel hier eine geringere Temperatur als im restlichen Bereich aufweist.

Der Einfluss der Isolationsdichte auf die Rotationssymmetrie des aufwachsenden SiC-Volumeneinkristalls wird anhand einiger Fallbeispiele näher erläutert.

So führt eine im Bereich des Kristallwachstumsbereichs lokal erhöhte Dichte der Isolation zu einer dort geringeren thermischen Isolationswirkung, verbunden damit zu einer an diesem Teil der Wachstumsgrenzfläche reduzierten Temperatur und als Folge davon zu einer lokal erhöhten Wachstumsgeschwindigkeit. Der aufwachsende SiC-Volumeneinkristall ist hier länger als anderen Stellen. Die Wachstumsgeschwindigkeit wird bei konstanter Temperatur nämlich hauptsächlich durch den axialen Temperaturgradienten bestimmt. Ein lokaler Dichteunterschied der Isolation führt zu einem lokal unterschiedlichen axialen Temperaturgradienten und damit zu einer unterschiedlichen lokalen Wachstumsgeschwindigkeit.

Umgekehrt führt eine im Bereich des Kristallwachstumsbereichs lokal reduzierte Dichte der Isolation zu einer dort höheren thermischen Isolationswirkung, verbunden damit zu einer an diesem Teil der Wachstumsgrenzfläche erhöhten Temperatur und als Folge davon zu einer lokal reduzierten Wachstumsgeschwindigkeit. Der aufwachsende SiC-Volumeneinkristall ist hier kürzer als anderen Stellen.

Eine im Bereich des SiC-Vorratsbereichs lokal erhöhte Dichte der Isolation führt zu einer dort niedrigeren thermischen Isolationswirkung, verbunden damit zu einer in diesem Teilbereich sinkenden Sublimationsrate und als Folge davon zu einer oberhalb dieser Stelle lokal reduzierten Wachstumsgeschwindigkeit. Der aufwachsende SiC-Volumeneinkristall ist hier kürzer als anderen Stellen.

Umgekehrt führt eine im Bereich des SiC-Vorratsbereichs lokal reduzierte Dichte der Isolation zu einer dort höheren thermischen Isolationswirkung, verbunden damit zu einer in diesem Teilbereich steigenden Sublimationsrate und als Folge davon zu einer oberhalb dieser Stelle lokal erhöhten Wachstumsgeschwindigkeit. Der aufwachsende SiC-Volumeneinkristall ist hier länger als anderen Stellen.

In allen vier Fällen resultiert jeweils ein SiC-Volumeneinkristall mit einer Abweichung von der eigentlich gewünschten perfekten Rotationssymmetrie, wodurch Qualität und Ausbeute sinken.

Um solche negativen Einflüsse auf die Rotationssymmetrie des Temperaturfelds und auch des aufwachsenden SiC-Volumeneinkristalls zu vermeiden, werden die Isolationseigenschaften ausgeglichen. Dieser vorteilhafte Ausgleich erfolgt durch die Aufteilung der (thermischen) Isolation in mehrere (mindestens zwei) Isolationsteilzylinder, die außerdem insbesondere gezielt nach ihren Isolationseigenschaften ausgewählt und dann insbesondere auch mit gezielter wechselseitiger Ausrichtung zueinander platziert werden. Als Maß dient dabei die Dichte, insbesondere die Volumenelementdichte. Letztere weicht bei entsprechend ausgewählten und zueinander platzierten Isolationsteilzylindern vorzugsweise bei keinem Volumenelement um mehr als 10% von der mittleren Isolationsringsegmentdichte des betreffenden Isolationsringsegments ab. Dadurch wird für die mehrteilig aus Teilkomponenten (= Isolationsteilzylinder) mit jeweils unvollkommen rotationssymmetrischem Isolationsverhalten aufgebaute Isolation ein Gesamt-Isolationsverhalten erreicht, das eine hochgradige, wenn nicht sogar perfekte Rotationssymmetrie hat, die besser ist als bei jeder der Teilkomponenten (= Isolationsteilzylinder). Es resultiert ein ebenfalls praktisch ideal rotationssymmetrisches Temperaturfeld.

Somit lassen sich rotationssymmetrische SiC-Volumeneinkristalle in hoher Qualität herstellen. Der bei der nachfolgenden Weiterverarbeitung wegen etwaiger Asymmetrien der SiC-Volumeneinkristalle bislang auftretende Materialverlust wird auf diese Weise signifikant verringert.

Je mehr Isolationsteilzylinder die Isolation enthält, umso besser lassen sich Dichteabweichungen in Teilbereichen der Isolationsteilzylinder ausgleichen. Andererseits steigen auch die Kosten mit jedem zusätzlichen Isolationsteilzylinder. Deshalb liegt eine technisch und wirtschaftlich vernünftige obere Grenze für die Anzahl der Isolationsteilzylinder bei insbesondere fünf. Die Isolation kann also insbesondere zwei, drei, vier oder fünf Isolationsteilzylinder haben. Ein sehr guter Kompromiss bezüglich aus technischer Sicht erwünschtem Ausgleich von Dichteabweichungen in den Isolationsteilzylindern und aus wirtschaftlicher Sicht erwünschter Kostenbegrenzung ist eine Isolation, die vorzugsweise drei Isolationsteilzylinder aufweist.

Es ist insbesondere möglich, mit dem erfindungsgemäßen Verfahren einen SiC-Volumeneinkristall oder zwei SiC-Volumeneinkristalle herzustellen. Pro Züchtungstiegel und Züchtungslauf lassen sich also vorzugsweise bis zu zwei SiC-Volumeneinkristalle herstellen.

Weiterhin kann der Züchtungstiegel insbesondere induktiv mittels mindestens einer Heizspule oder resistiv mittels einer Widerstandsheizung beheizt werden.

Weitere vorteilhafte Ausgestaltungen des erfindungsgemäßen Verfahrens ergeben sich aus den Merkmalen der von Anspruch 1 abhängigen Ansprüche.

Günstig ist eine Ausgestaltung, bei der für die Isolation ein Isolationsmaterial mit einer Materialdichte zwischen 0,05 g/cm³ und 0,5 g/cm³, insbesondere zwischen 0,1 g/cm³ und 0,2 g/cm³, gewählt wird. Ein besonders gut geeignetes Isolationsmaterial ist insbesondere kohlenstoffbasiert. Auch reiner Kohlenstoff, beispielsweise in Form von Graphit oder graphitartigem Kohlenstoff, kann zum Einsatz kommen. Vorzugsweise setzt sich ein solches kohlenstoffbasiertes Isolationsmaterial aus Langfasern oder Kurzfasern zusammen. Rotationssymmetrische Kurzfaserisolationen werden dabei beispielsweise durch Karbonisierung von Mischungen aus Kohlenstofffasern und Phenolharz, durch anschließende thermische Behandlung(en) und durch mechanisches Bearbeiten in die endgültige Form gebracht. Insgesamt wird mit solchen Isolationsmaterialien eine sehr gute thermische Isolierung des Züchtungstiegels erreicht.

Gemäß einer weiteren günstigen Ausgestaltung wird vor Züchtungsbeginn an den mindestens zwei Isolationsteilzylindern eine Dichtebestimmung mittels eines röntgenographischen Verfahrens durchgeführt. Insbesondere wird mittels dieses Röntgenverfahrens eine Dichteverteilung innerhalb jedes der mindestens zwei Isolationsteilzylinder bestimmt. Vorzugsweise kann auch die Isolation nach ihrem Zusammenbau aus den einzelnen Isolationsteilzylindern abschließend nochmals einer solchen röntgenographischen Untersuchung unterzogen werden, um zu überprüfen, ob der Gesamtaufbau der Isolation die gewünschte rotationssymmetrische Dichteverteilung aufweist. Ebenso kann eine solche Röntgenuntersuchung vor einer erneuten Verwendung einer Isolation durchgeführt werden. Anhand des röntgenographischen Untersuchungsverfahrens können sehr gut detaillierte Informationen zur lokalen Verteilung der Dichte in den Isolationsteilzylindern und auch der Isolation insgesamt ermittelt werden.

Gemäß einer weiteren günstigen Ausgestaltung werden die mindestens zwei Isolationsteilzylinder so ausgewählt und zueinander platziert, dass jedes Volumenelement des betreffenden Isolationsringsegments eine Volumenelementdichte hat, die um höchstens 5% von der mittleren Isolationsringsegmentdichte des betreffenden Isolationsringsegments abweicht. Dadurch ergibt sich ein noch höherer Grad an Rotationssymmetrie der Dichteverteilung in den Isolationsteilzylindern und als Folge davon des Temperaturfelds im Züchtungstiegel.

Letzteres gilt auch für eine weitere günstige Ausgestaltung, gemäß der das jeweilige Isolationsringsegment und die Volumenelemente dieses Isolationsringsegments so gewählt werden, dass die axiale Elementlänge der Volumenelemente 20 mm und die äußere tangentiale Elementlänge der Volumenelemente 20 mm beträgt. Mit sinkender axialer und/oder äußerer tangentialer Elementlänge steigt die Homogenität der Isolation, was sich positiv auf die Rotationssymmetrie des aufwachsenden SiC-Volumeneinkristalls auswirkt.

Gemäß einer weiteren günstigen Ausgestaltung werden die mindestens zwei Isolationsteilzylinder so gewählt, dass ihre radiale Wandstärke jeweils im Bereich zwischen 5 mm und 50 mm, insbesondere zwischen 10 mm und 20 mm, liegt. Mit diesen Wandstärken wird eine sehr gute thermische Isolierung des Züchtungstiegels erreicht. Außerdem wird damit die mechanische Belastung der Isolation durch die im Züchtungstiegel bei den hohen Züchtungstemperaturen von bis zu über 2000°C auftretenden thermischen Spannungen möglichst gering gehalten. Auf der Außenseite liegt die Temperatur innerhalb einer beispielsweise dort vorhandenen Wasserkühlung nahe der Raumtemperatur, die typischerweise etwa 25°C beträgt. Es liegt also ein sehr starkes Temperaturgefälle auf engstem Raum vor, das zu den angesprochenen thermischen Spannungen führen kann.

Gemäß einer weiteren günstigen Ausgestaltung werden die mindestens zwei Isolationsteilzylinder so gewählt, dass ein Quotient zweier insbesondere beliebiger der radialen Wandstärken im Bereich zwischen 0,5 und 2 liegt. Die radialen Wandstärken können also z.B. gleich groß sein, aber auch in gewissem Umfang, nämlich um einen Faktor von bis zu 2, voneinander abweichen. Auch dies dient der Reduzierung der mechanischen Belastung der Isolation durch thermischen Spannungen.

Gemäß einer weiteren günstigen Ausgestaltung wird die Isolation so aufgebaut, dass zwei zueinander benachbarte der mindestens zwei Isolationsteilzylinder jeweils einen radialen Abstand im Bereich zwischen 0,1 mm und 5 mm, insbesondere zwischen 1 mm und 2 mm, aufweisen. Dieser radiale Spalt zwischen benachbarten Isolationsteilzylindern erleichtert während der Montage das Einsetzen eines der Isolationsteilzylinder in den anderen. Außerdem werden so mechanische Verspannungen der Isolation aufgrund thermischer Ausdehnungen während des Züchtungsbetriebs vermieden.

Zur Lösung der die Züchtungsanordnung betreffenden Aufgabe wird eine Züchtungsanordnung entsprechend den Merkmalen des Anspruchs 9 angegeben.

Die erfindungsgemäße Züchtungsanordnung zur Herstellung mindestens eines SiC-Volumeneinkristalls mittels Sublimationszüchtung hat einen Züchtungstiegel mit mindestens einem Kristallwachstumsbereich, der jeweils zur Aufnahme eines SiC-Keimkristalls bestimmt ist, und mit mindestens einem SiC-Vorratsbereich, der zur Aufnahme von insbesondere pulverförmigem SiC-Quellmaterial bestimmt ist, und eine Heizeinrichtung zur Erhitzung des Züchtungstiegels, so dass während der Züchtung eine Sublimation des SiC-Quellmaterials, ein Transport der sublimierten gasförmigen Komponenten in den mindestens einen Kristallwachstumsbereich und dort eine Erzeugung einer SiC-Wachstumsgasphase stattfindet, wodurch der mindestens eine eine zentrale Mittenlängsachse aufweisende SiC-Volumeneinkristall mittels Abscheidung aus der SiC-Wachstumsgasphase auf dem mindestens einen SiC-Keimkristall aufwächst. Der Züchtungstiegel ist von einer rotationssymmetrischen und sich axial in Richtung der zentralen Mittenlängsachse erstreckenden insbesondere thermischen Isolation umgeben, die mindestens zwei Isolationsteilzylinder aufweist, wobei die mindestens zwei Isolationsteilzylinder konzentrisch zueinander angeordnet und ineinander gesetzt sind, und jeder der mindestens zwei Isolationsteilzylinder eine in einer radialen Richtung gemessene Wandstärke hat. Die Isolation ist fiktiv in mehrere axial in Richtung der zentralen Mittenlängsachse hintereinander angeordnete Isolationsringsegmente aufgeteilt, und jedes dieser Isolationsringsegmente ist seinerseits fiktiv in mehrere in einer tangentialen Richtung nebeneinander angeordnete Volumenelemente aufgeteilt. Jedes dieser Isolationsringsegmente weist jeweils eine über die Wandstärken aller der mindestens zwei Isolationsteilzylinder gemessene mittlere Isolationsringsegmentdichte auf. Die mindestens zwei Isolationsteilzylinder, die jeweils Dichteabweichungen in Teilbereichen haben, sind so ausgewählt und zueinander platziert, dass jedes Volumenelement des betreffenden Isolationsringsegments eine Volumenelementdichte hat, die um höchstens 10% von der mittleren Isolationsringsegmentdichte des betreffenden Isolationsringsegments abweicht, wobei sich jedes Volumenelement in axialer Richtung über eine axiale Elementlänge, die gleich groß wie eine axiale Segmentlänge des Isolationsringsegments ist und die bis zu 50 mm beträgt, in Umfangsrichtung über eine äußere tangentiale Elementlänge von bis zu 50 mm und in radialer Richtung über die Addition aller Wandstärken der mindestens zwei Isolationsteilzylinder erstreckt.

Vorteilhafte Ausgestaltungen der erfindungsgemäßen Züchtungsanordnung ergeben sich aus den von Anspruch 9 abhängigen Ansprüchen. Die erfindungsgemäße Züchtungsanordnung und ihre Ausgestaltungen haben im Wesentlichen die gleichen Vorteile, die bereits im Zusammenhang mit dem erfindungsgemäßen Verfahren und dessen Ausgestaltungen beschrieben worden sind.

Weitere Merkmale, Vorteile und Einzelheiten der Erfindung ergeben sich aus der nachfolgenden Beschreibung von Ausführungsbeispielen anhand der Zeichnung. Es zeigt:
- Fig. 1: ein Ausführungsbeispiel einer Züchtungsanordnung mit einer thermischen Isolation mit zwei Isolationsteilzylindern während der Sublimationszüchtung eines SiC-Volumeneinkristalls in einer Längsschnittdarstellung,
- Fig. 2 und 3: die zwei Isolationsteilzylinder gemäß Fig. 1 in perspektivischen Detaildarstellungen,
- Fig. 4: ein Ausführungsbeispiel einer Untersuchungsanordnung zur röntgenographischen Untersuchung eines Isolationsteilzylinders einer mehrteiligen thermischen Isolation, und
- Fig. 5: ein weiteres Ausführungsbeispiel einer Züchtungsanordnung mit einer thermischen Isolation mit drei Isolationsteilzylindern während der Sublimationszüchtung zweier SiC-Volumeneinkristalle in einer Längsschnittdarstellung.

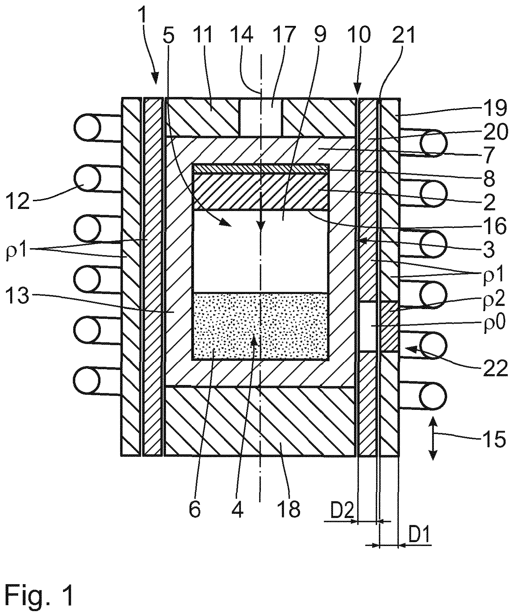

Einander entsprechende Teile sind in den Fig. 1 bis 5 mit denselben Bezugszeichen versehen. Auch Einzelheiten der im Folgenden näher erläuterten Ausführungsbeispiele können für sich genommen eine Erfindung darstellen oder Teil eines Erfindungsgegenstands sein.

In Fig. 1 ist ein Ausführungsbeispiel einer Züchtungsanordnung 1 zur Herstellung eines SiC-Volumeneinkristalls 2 mittels Sublimationszüchtung dargestellt. Die Züchtungsanordnung 1 enthält einen Züchtungstiegel 3, der einen SiC-Vorratsbereich 4 sowie einen Kristallwachstumsbereich 5 umfasst. In dem SiC-Vorratsbereich 4 befindet sich beispielsweise pulverförmiges SiC-Quellmaterial 6, das als vorgefertigtes Ausgangsmaterial vor Beginn des Züchtungsprozesses in den SiC-Vorratsbereich 4 des Züchtungstiegels 3 eingefüllt wird.

Im Bereich einer dem SiC-Vorratsbereich 4 gegenüberliegenden Tiegelstirnwand 7 des Züchtungstiegels 3 ist ein sich axial bis in den Kristallwachstumsbereich 5 erstreckender SiC-Keimkristall 8 angebracht. Der SiC-Keimkristall 8 ist insbesondere einkristallin. Die Tiegelstirnwand 7 kann als Tiegeldeckel des Züchtungstiegels 3 ausgebildet sein. Dies ist aber nicht zwingend. Auf dem SiC-Keimkristall 8 wächst der zu züchtende SiC-Volumeneinkristall 2 mittels Abscheidung aus einer sich im Kristallwachstumsbereich 5 ausbildenden SiC-Wachstumsgasphase 9 auf. Der aufwachsende SiC-Volumeneinkristall 2 und der SiC-Keimkristall 8 haben in etwa den gleichen Durchmesser. Wenn überhaupt, ergibt sich eine Abweichung von höchstens 20%, um die ein Keimdurchmesser des SiC-Keimkristalls 8 kleiner oder größer ist als ein Einkristalldurchmesser des SiC-Volumeneinkristalls 2. Allerdings kann zwischen der Innenseite einer Tiegelseitenwand 13 einerseits und dem aufwachsenden SiC-Volumeneinkristall 2 sowie dem SiC-Keimkristall 8 andererseits ein in Fig. 1 nicht gezeigter Spalt vorhanden sein.

Der Züchtungstiegel 3 besteht bei dem Ausführungsbeispiel gemäß Fig. 1 aus einem elektrisch und thermisch leitfähigen Graphit-Tiegelmaterial mit einer Dichte von z.B. mindestens 1,75 g/cm³. Um ihn herum ist eine thermische Isolation 10 angeordnet, welche beim gezeigten Ausführungsbeispiel mehrteilig ausgebildet ist. Die Isolation 10 besteht z.B. aus kohlenstoffbasiertem Isolationsmaterial mit langen oder kurzen Fasern. Das Isolationsmaterial hat eine Materialdichte, die beim gezeigten Ausführungsbeispiel bei etwa 0,2 g/cm³ liegt.

Zur Beheizung des Züchtungstiegels 3 ist außen um den thermisch isolierten Züchtungstiegel 3 eine induktive Heizeinrichtung in Form einer Heizspule 12 angeordnet. Der Züchtungstiegel 3 wird mittels der Heizspule 12 auf die für die Züchtung erforderlichen Temperaturen erhitzt. Bei dem gezeigten Ausführungsbeispiel liegen diese Wachstumstemperaturen bei mindestens 2100°C. Die Heizspule 12 koppelt einen elektrischen Strom induktiv in die elektrisch leitfähige Tiegelseitenwand 13 des Züchtungstiegels 3 ein. Dieser elektrische Strom fließt im Wesentlichen als Kreisstrom in Umfangsrichtung innerhalb der kreis- und hohlzylindrischen Tiegelseitenwand 13 und heizt dabei den Züchtungstiegel 3 auf. Bei Bedarf kann die relative Position zwischen der Heizspule 12 und dem Züchtungstiegel 3 axial, d.h. in die Richtung einer Mittenlängsachse 14 des aufwachsenden SiC-Volumeneinkristalls 2, verändert werden, insbesondere um die Temperatur bzw. den Temperaturverlauf innerhalb des Züchtungstiegels 3 einzustellen und ggf. auch zu verändern. Die während des Züchtungsprozesses axial veränderbare Position der Heizspule 12 ist in Fig. 1 durch den Doppelpfeil 15 angedeutet. Insbesondere wird die Heizspule 12 an den Wachstumsfortschritt des aufwachsenden SiC-Volumeneinkristalls 2 angepasst verschoben. Die Verschiebung erfolgt vorzugsweise nach unten, also in Richtung des SiC-Quellmaterials 6, und bevorzugt um die gleiche Länge, um die der SiC-Volumeneinkristall 2 aufwächst, z.B. insgesamt um etwa 20 mm. Hierzu umfasst die Züchtungsanordnung 1 nicht näher gezeigte entsprechend ausgestaltete Kontroll-, Steuer- und Verstellmittel.

Die SiC-Wachstumsgasphase 9 im Kristallwachstumsbereich 5 wird durch das SiC-Quellmaterial 6 gespeist. Die SiC-Wachstumsgasphase 9 enthält zumindest Gasbestandteile in Form von Si, Si₂C und SiC₂ (= SiC-Gasspezies). Der Materialtransport vom SiC-Quellmaterial 6 zu einer Wachstumsgrenzfläche 16 am aufwachsenden SiC-Volumeneinkristall 2 erfolgt einerseits längs eines axialen Temperaturgradienten. An der Wachstumsgrenzfläche 16 herrscht eine relativ hohe Wachstumstemperatur von mindestens 2100°C, insbesondere sogar von mindestens 2200°C oder 2300°C°. Außerdem wird an der Wachstumsgrenzfläche 16 insbesondere ein in Richtung der Mittenlängsachse 14 gemessener axialer Temperaturgradient von mindestens 5 K/cm, vorzugsweise von mindestens 15 K/cm, eingestellt. Die Temperatur innerhalb des Züchtungstiegels 3 nimmt zu dem aufwachsenden SiC-Volumeneinkristall 2 hin ab. Die höchste Temperatur liegt mit etwa 2300°C bis 2500°C im Bereich des SiC-Vorratsbereichs 4. Dieser Temperaturverlauf mit einer Temperaturdifferenz von insbesondere 100°C bis 150°C zwischen dem SiC-Vorratsbereich 4 und der Wachstumsgrenzfläche 16 lässt sich über verschiedene Maßnahmen erreichen. So kann über eine nicht näher gezeigte Aufteilung der Heizspule 12 in zwei oder mehrere axiale Teilabschnitte eine axial variierende Beheizung vorgesehen werden. Weiterhin kann im unteren Abschnitt des Züchtungstiegels 3, z.B. durch eine entsprechende axiale Positionierung der Heizspule 12, eine stärkere Heizwirkung eingestellt werden als im oberen Abschnitt des Züchtungstiegels 3.

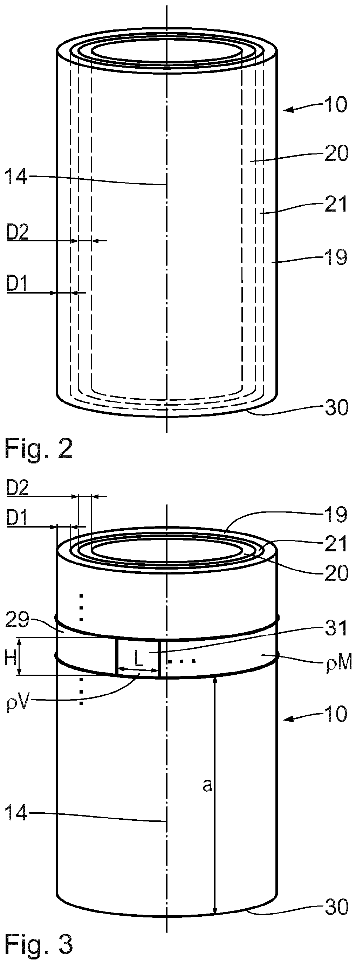

Die thermische Isolation 10 hat einen oberen axialen Isolationsdeckel 11, der benachbart zu der oberen Tiegelstirnwand 7 angeordnet ist und eine um die Mittenlängsachse 14 angeordnete zentrale Kühlöffnung 17 enthält. Durch die Kühlöffnung 17 kann Wärme abgeführt werden und/oder eine Überwachung des Züchtungstiegels 3 erfolgen. Außerdem hat die thermische Isolation 10 einen unteren axialen Isolationsdeckel 18, der unterhalb des SiC-Vorratsbereichs 4 angeordnet ist, sowie zwei Isolationsteilzylinder 19 und 20, die konzentrisch zur Mittenlängsachse 14 und auch konzentrisch zueinander angeordnet sind. Letztere umgeben die Tiegelseitenwand 13. Der Isolationsteilzylinder 20 ist in den Isolationsteilzylinder 19 gesetzt (siehe auch Fig. 2 und 3). Der äußere Isolationsteilzylinder 19 hat eine in radialer Richtung gemessene Wandstärke D1, der innere Isolationsteilzylinder 20 hat eine ebenfalls in radialer Richtung gemessene Wandstärke D2. Die thermische Isolation 10 hat, wie auch der Züchtungstiegel 3, einen bezogen auf die Mittenlängsachse 14 rotationssymmetrischen Aufbau. Dies gilt außerdem insbesondere auch für die beiden Isolationsteilzylinder 19, 20. Die thermische Isolation 10 erstreckt sich axial in Richtung der zentralen Mittenlängsachse 14.

Gemäß der insofern deutlicheren teiltransparenten perspektivischen Darstellung von Fig. 2 liegen die beiden Isolationsteilzylindern 19, 20 nicht unmittelbar aneinander an. Zwischen ihnen ist vielmehr ein Abstandsspalt 21 mit einer radialen Ausdehnung im Bereich zwischen 0,1 mm und 5 mm, insbesondere zwischen 1 mm und 2 mm, vorhanden. Beim gezeigten Ausführungsbeispiel hat der Abstandsspalt 21 einen Wert von etwa 1 mm. Der Abstandsspalt 21 erleichtert während der Montage das Einsetzen des inneren Isolationsteilzylinders 20 in den äußeren Isolationsteilzylinder 19. Außerdem trägt er dazu bei, dass es während des Züchtungsprozesses zu keinen maßgeblichen mechanischen Verspannungen zwischen den beiden Isolationsteilzylindern 19, 20 kommt.

Der konstruktive mechanische Aufbau der Isolationsteilzylinder 19, 20 ist zwar jeweils rotationssymmetrisch. Dennoch gilt dies nicht für alle Materialeigenschaften, insbesondere nicht für die Verteilung der Materialdichte in tangentialer Richtung. Hier kann es zu Abweichungen kommen, so dass die Dichteverteilung innerhalb der Wände der Isolationsteilzylinder 19, 20 nicht überall absolut rotationssymmetrisch ist. In Fig. 1 ist beispielhaft in axialer Richtung auf Höhe des SiC-Vorratsbereichs 4 in beiden Isolationsteilzylindern 19, 20 eine Abweichungsstelle 22 dargestellt. Dort weichen die lokalen Dichten ρ0 und ρ2 im inneren Isolationsteilzylinder 20 bzw. im äußeren Isolationsteilzylinder 19 von der ansonsten in beiden Isolationsteilzylindern 19, 20 gegebenen Grund-Dichte ρ1 ab. Die lokale Dichte ρ0 des inneren Isolationsteilzylinders 20 ist dort kleiner und die lokale Dichte ρ2 des äußeren Isolationsteilzylinders 19 ist dort größer als die Grund-Dichte ρ1. Es gilt: ρ0 < ρ1 < ρ2. Die beiden Isolationsteilzylinder 19, 20 sind gezielt so ausgewählt und relativ zueinander platziert, dass sich die lokalen Dichteabweichungen an der Abweichungsstelle 22 gegenseitig weitestgehend ausgleichen, um insgesamt in der thermischen Isolation 10 eine über die Wandstärken D1 und D2 beider Isolationsteilzylinder 19, 20 betrachtet möglichst ideale Rotationssymmetrie der Dichteverteilung zu haben. Bei einer rotationssymmetrischen Dichteverteilung in der thermischen Isolation 10 stellt sich innerhalb des Züchtungstiegels 3 ein rotationssymmetrisches Temperaturfeld ein, wodurch der SiC-Volumeneinkristall 2 ebenfalls rotationssymmetrisch und damit sehr homogen und defektfrei aufwächst.

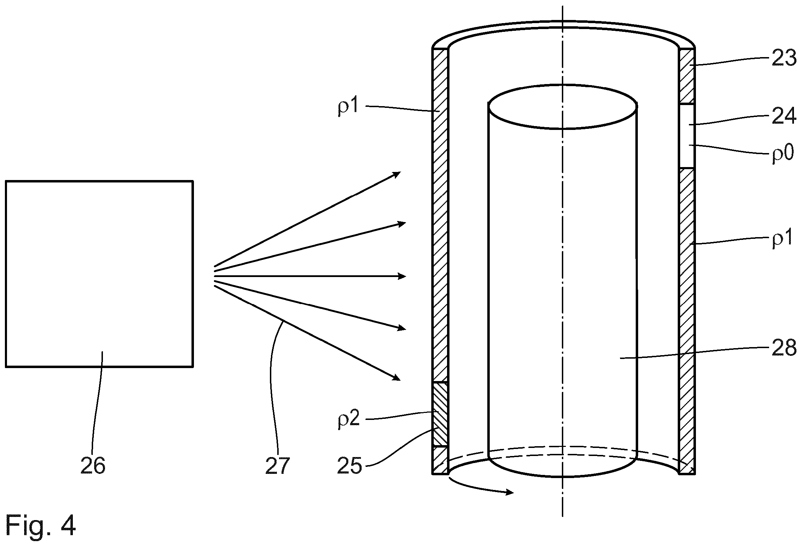

Um den beschriebenen vorteilhaften Ausgleich von lokalen Dichteabweichungen in der thermischen Isolation 10 bewerkstelligen zu können, wird bei den beteiligten Isolationsteilzylindern 19, 20 zunächst die Verteilung der Materialdichte ermittelt. Dies erfolgt wie aus Fig. 4 ersichtlich mittels eines Röntgenverfahrens. Dargestellt ist die Untersuchung eines anderen Isolationsteilzylinders 23, dessen Materialdichte an zwei Abweichungsstellen 24 und 25 von der Grund-Dichte ρ1 abweicht. Die lokal abweichenden Dichten sind wiederum mit ρ0 und p2 bezeichnet. Außerhalb des zu untersuchenden Isolationsteilzylinders 23 befindet sich eine Röntgenquelle 26, mittels der Röntgenstrahlung 27 auf den Isolationsteilzylinders 23 gestrahlt wird. Im Inneren des Isolationsteilzylinders 23 ist ein Detektor 28 platziert, der die Röntgenstrahlung 27 nach dem Passieren der Wand des Isolationsteilzylinders 23 erfasst. Anhand der empfangenen Röntgenstrahlung 27 kann dann auf die Materialdichte des Isolationsteilzylinders 23 an der durchstrahlten Stelle rückgeschlossen werden. Der Isolationsteilzylinder 23 wird an jeder Stelle auf diese Weise untersucht. Er wird dazu beispielsweise gedreht. Am Ende der Untersuchung liegt eine vollständige Beschreibung der Dichteverteilung innerhalb des Isolationsteilzylinders 23 vor. Insbesondere ist dann bekannt, wo lokale Abweichungen von der Grund-Dichte ρ1 vorliegen und wie groß diese Abweichungen sind.

Anhand dieser Informationen können die zum Aufbau der thermischen Isolation 10 zu verwendenden Isolationsteilzylinder 19, 20 ausgewählt und so zueinander positioniert werden, dass sich lokale Dichteabweichungen ausgleichen. Das dabei zugrunde gelegte Auswahl-/Prüfungskriterium wird anhand der Abbildung von Fig. 3 am Beispiel der thermischen Isolation 10 mit den beiden Isolationsteilzylindern 19, 20 der Züchtungsanordnung 1 gemäß Fig. 1 näher erläutert.

So wird die thermische Isolation 10 mit den beiden Isolationsteilzylindern 19, 20 fiktiv in mehrere axial in Richtung der zentralen Mittenlängsachse 14 hintereinander angeordnete Isolationsringsegmente aufgeteilt. Hiervon ist in der Darstellung gemäß Fig. 3 beispielhaft eines, nämlich das Isolationsringsegment 29, wiedergegeben. Jedes dieser Isolationsringsegmente weist einen anderen axialen Abstand a von einem axialen Rand 30 der thermischen Isolation 10 auf. Im Beispiel gemäß Fig. 3 ist der Rand 30 der untere axiale Rand der thermischen Isolation 10. Jedes dieser Isolationsringsegmente wird seinerseits fiktiv in mehrere in tangentialer Richtung nebeneinander angeordnete Volumenelemente aufgeteilt. Hiervon ist in der Darstellung gemäß Fig. 3 beispielhaft eines, nämlich das Volumenelement 31, wiedergegeben. Jedes Isolationsringsegment, so auch das Isolationsringsegment 29, hat eine mittlere Isolationsringsegmentdichte pM, die durch Mittelung der in allen Isolationsteilzylindern, hier in den beiden Isolationsteilzylindern 19, 20, im Bereich des betreffenden Isolationsringsegments herrschenden lokalen Dichtewerte bestimmt wird. Bei der Bestimmung der jeweiligen mittleren Isolationsringsegmentdichte pM werden also die Dichteverhältnisse innerhalb der Wände aller vorhandenen Isolationsteilzylinder berücksichtigt, jeweils im Bereich des betreffenden Isolationsringsegments. Unberücksichtigt bleiben dagegen die Verhältnisse im Abstandsspalt 21 zwischen den beiden Isolationsteilzylindern 19, 20. Die beteiligten Isolationsteilzylinder, hier die Isolationsteilzylinder 19, 20, werden so ausgewählt und zueinander platziert, dass jedes Volumenelement des betreffenden Isolationsringsegments, so auch das Volumenelement 31 des Isolationsringsegments 29, eine Volumenelementdichte pV hat, die um höchstens 10%, vorzugsweise sogar nur um höchstens 5%, von der mittleren Isolationsringsegmentdichte pM des betreffenden Isolationsringsegments abweicht. Diese Bedingung gilt für alle Isolationsringsegmente. Die für diese Prüfung benötigten lokalen Dichtewerte der Isolationsteilzylinder 19, 20 sind insbesondere aus der vorher durchgeführten röntgenographischen Untersuchung gemäß Fig. 4 bekannt.

Das Volumenelement 31 erstreckt sich (wie jedes andere Volumenelement des Isolationsringsegments 29) in axialer Richtung über eine axiale Elementlänge H, die gleich groß wie eine axiale Segmentlänge des Isolationsringsegments 29 ist. Außerdem erstreckt sich das Volumenelement 31 in tangentialer Richtung über eine äußere tangentiale Elementlänge L und in radialer Richtung über die Addition der radialen Wandstärken aller beteiligter Isolationsteilzylinder, hier also über die Wandstärken D1 und D2 der Isolationsteilzylinder 19, 20. Die axiale Elementlänge H und auch die äu-ßere tangentiale Elementlänge L liegen jeweils im Bereich zwischen 10 mm und 50 mm, insbesondere jeweils bei 50 mm oder jeweils bei 20 mm. Die Wandstärken D1 und D2 liegen im Bereich zwischen 5 mm und 50 mm, insbesondere zwischen 10 mm und 20 mm. Sie können, müssen aber nicht zwingend gleich groß sein. Dies gilt auch, wenn mehr als die beiden Isolationsteilzylinder 19, 20 vorhanden sein sollten.

Unter Berücksichtigung des vorstehenden Auswahl-/Prüfungskriteriums sind für die thermische Isolation 10 die beiden Isolationsteilzylinder 19, 20 als geeignet ausgewählt worden. Die Isolationsteilzylinder 19, 20 sind dann wiederum unter Berücksichtigung des vorstehenden Auswahl-/Prüfungskriteriums mit geeigneter Orientierung zueinander zusammengefügt worden. Die so hergestellte thermische Isolation 10 kann dann nochmals einer röntgenographischen Untersuchung gemäß Fig. 4 unterzogen werden, um zu überprüfen, ob die Dichteverteilung des Gesamtaufbaus eine ausreichende Rotationssymmetrie aufweist.

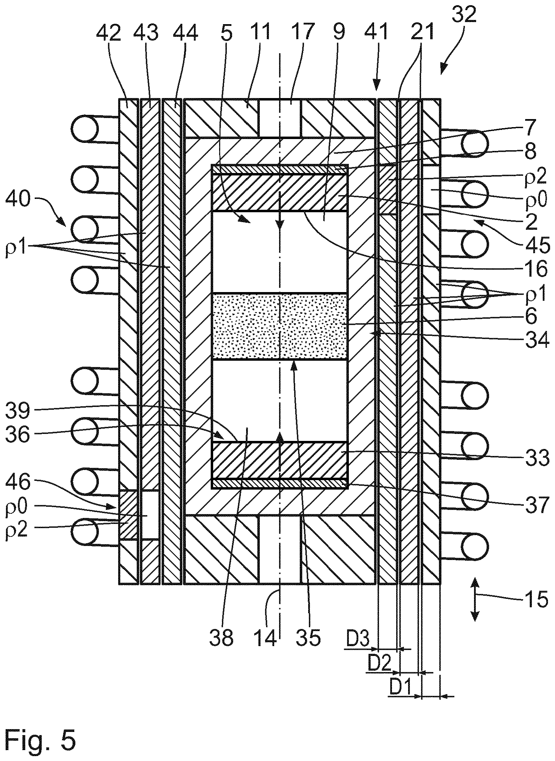

In Fig. 5 ist ein weiteres Ausführungsbeispiel einer Züchtungsanordnung 32 gezeigt, die ähnlich zur Züchtungsanordnung 1 realisiert ist. Mit der Züchtungsanordnung 32 kann parallel zum SiC-Volumeneinkristall 2 ein zweiter SiC-Volumeneinkristall 33 hergestellt werden. Dazu ist der bei der Züchtungsanordnung 1 innerhalb des Züchtungstiegels 3 vorgesehene Aufbau im Wesentlichen durch eine Spiegelung am Boden des Züchtungstiegels 3 verdoppelt. Die Züchtungsanordnung 32 enthält dementsprechend einen Züchtungstiegel 34, bei dem ein SiC-Vorratsbereich 35 nicht am Boden, sondern in Richtung der Mittenlängsachse 14 betrachtet mittig angeordnet ist. Oberhalb des SiC-Vorratsbereichs 35 befindet sich der erste Kristallwachstumsbereich 5, unterhalb ein zweiter Kristallwachstumsbereich 36. In den beiden Kristallwachstumsbereichen 5 und 36 wächst jeweils einer der beiden SiC-Volumeneinkristalle 2 und 33 auf. Am Boden des Züchtungstiegels 34 ist ein zweiter SiC-Keimkristall 37 angeordnet, auf dem der zweite SiC-Volumeneinkristall 33 aus einer sich im Kristallwachstumsbereich 36 ausbildenden und durch das im SiC-Vorratsbereich 35 befindliche SiC-Quellmaterial 6 gespeisten SiC-Wachstumsgasphase 38 aufwächst. Dabei verschiebt sich eine Wachstumsgrenzfläche 39 des zweiten SiC-Volumeneinkristalls 33 in Richtung einer parallel zur Mittenlängsachse 14 orientierten Wachstumsrichtung, die aber entgegengesetzt zur Wachstumsrichtung des ersten SiC-Volumeneinkristalls 2 ist. Die Mittenlängsachse 14 gilt für die beiden SiC-Volumeneinkristalle 2, 33 insbesondere gleichermaßen. Die Mittenlängsachse 14 ist insofern vorzugsweise eine gemeinsame Achse beider SiC-Volumeneinkristalle 2, 33.

Insgesamt hat der Züchtungstiegel 34 einen bezüglich einer mittig in Richtung der Mittenlängsachse 14 innerhalb des SiC-Vorratsbereichs 35 angeordneten und quer zur Mittenlängsachse 14 verlaufenden (in Fig. 5 nicht mit dargestellten) Querebene in Richtung der Mittenlängsachse 14 gespiegelten bzw. symmetrischen Aufbau. Bezüglich der Mittenlängsachse 14 ist der Züchtungstiegel 34 rotationssymmetrisch. Zur Beheizung des Züchtungstiegels ist eine mehrteilige Heizspule 40 vorhanden.

Ein weiterer Unterschied zur Züchtungsanordnung 1 gemäß Fig. 1 besteht darin, dass die Züchtungsanordnung 32 eine thermische Isolation 41 mit drei konzentrisch zur Mittenlängsachse 14 und konzentrisch zueinander angeordneten Isolationsteilzylindern 42, 43, 44 hat. Der innere Isolationsteilzylinder 44 ist in den mittleren Isolationsteilzylinder 43 gesetzt, welcher seinerseits in den äußeren Isolationsteilzylinder 42 gesetzt ist. Der äußere Isolationsteilzylinder 42 hat eine radiale Wandstärke D1, der mittlere Isolationsteilzylinder 43 eine radiale Wandstärke D2 und der innere Isolationsteilzylinder 44 eine radiale Wandstärke D3. Zwischen benachbarten der Isolationsteilzylinder 42, 43, 44 ist jeweils ein Abstandsspalt 21 vorhanden. Auch die thermische Isolation 41 hat einen rotationssymmetrischen Aufbau, was insbesondere wiederum auch für die drei Isolationsteilzylinder 42, 43, 44 gilt.

Allerdings haben auch die Isolationsteilzylinder 42, 43, 44 keine perfekte Rotationssymmetrie bei allen Materialeigenschaften. Insbesondere bei der Dichteverteilung treten Abweichungen auf. So gibt es zwei Abweichungsstellen 45 und 46. Die erste Abweichungsstelle 45 befindet sich auf Höhe des ersten Kristallwachstumsbereichs 5. Dort weicht die lokale Dichte ρ0 im äußeren Isolationsteilzylinder 42 und die lokale Dichte ρ2 im inneren Isolationsteilzylinder 44 von der ansonsten in den drei Isolationsteilzylindern 42, 43, 44 gegebenen Grund-Dichte ρ1 ab. Die zweite Abweichungsstelle 46 befindet sich auf Höhe des zweiten SiC-Keimkristalls 37. Dort weicht die lokale Dichte ρ0 im mittleren Isolationsteilzylinder 43 und die lokale Dichte ρ2 im äußeren Isolationsteilzylinder 42 von der Grund-Dichte ρ1 ab. Es gilt jeweils wieder: ρ0 < ρ1 < p2. Auch bei der Züchtungsanordnung 32 sind die drei Isolationsteilzylinder 42, 43, 44 anhand des vorstehend erläuterten Auswahl-/Prüfungskriteriums gezielt so ausgewählt und relativ zueinander platziert, dass sich die lokalen Dichteabweichungen an den Abweichungsstellen 45 und 46 gegenseitig weitestgehend ausgleichen. So hat die thermische Isolation 41 insgesamt eine über die Wandstärken D1, D2 und D3 der drei Isolationsteilzylinder 42, 43, 44 betrachtet weitgehend ideal rotationssymmetrische Dichteverteilung. Insofern stellt sich auch innerhalb des Züchtungstiegels 34 ein rotationssymmetrisches Temperaturfeld ein, wodurch die beiden SiC-Volumeneinkristalle 2 und 33 rotationssymmetrisch und damit sehr homogen und defektfrei aufwachsen.

Grundsätzlich ist die Verwendung der thermischen Isolation 41 mit den drei Isolationsteilzylindern 42, 43, 44 nicht auf die Züchtungsanordnung 32 gemäß Fig. 5 zur Züchtung zweier SiC-Volumeneinkristalle 2, 33 beschränkt. Drei (oder auch mehr) Isolationsteilzylinder können auch bei anderen Züchtungsanordnungen, beispielsweise bei der Züchtungsanordnung 1 gemäß Fig. 1, zum Einsatz kommen. Ziel dabei ist es jeweils, dass die mit diesen Isolationsteilzylindern aufgebaute thermische Isolation insgesamt eine Dichteverteilung mit möglichst perfekter Rotationssymmetrie aufweist, um auf diese Weise ein rotationssymmetrisches Aufwachsen der herzustellenden SiC-Volumeneinkristalle zu unterstützen.

Insofern ermöglichen die Züchtungsanordnungen 1 und 32 die Herstellung hochqualitativer SiC-Volumeneinkristalle 2, 33, die mit hoher Ausbeute zu Bauelementen weiter verarbeitet werden können.

Insbesondere können SiC-Volumeneinkristalle 2, 33 hergestellt werden, bei denen jeweils der maximale und der minimale Längenunterschied zwischen Kristalloberfläche und Kristallrückseite am Kristallrand um maximal 10% von der gemessenen mittleren Kristalllänge am Kristallrand abweichen. An der durch den Bearbeitungsdurchmesser, welcher gleich dem Substratdurchmesser der später aus den SiC-Volumeneinkristallen 2, 33 gewonnenen einkristallinen SiC-Substrate (= SiC-Wafer) ist, bestimmten Bearbeitungsumfangslinie weichen der maximale und der minimale Längenunterschied zwischen Kristalloberfläche und Kristallrückseite der SiC-Volumeneinkristalle 2, 33 um maximal 5% von der an der Bearbeitungsumfangslinie gemessenen mittleren Kristalllänge ab. Insbesondere weisen die hergestellten SiC-Volumeneinkristalle 2, 33 im Wesentlichen nur einen einzigen SiC-Polytyp auf, beispielsweise 4H-SiC, 6H-SiC, 3C-SiC oder 15R-SiC. Bevorzugt ist 4H-SiC. Weiterhin kann die Kristallstruktur der SiC-Volumeneinkristalle 2, 33 eine geringfügig verkippte Orientierung (= off Orientierung) haben, wobei der Verkippungswinkel im Bereich zwischen 0° und 8°, vorzugsweise bei 4°, liegt. Die SiC-Volumeneinkristalle 2, 33 haben einen Kristalldurchmesser von insbesondere mindestens 100 mm, vorzugsweise von mindestens 150 mm. Eine Obergrenze des Kristalldurchmessers liegt insbesondere bei 250 mm. Ein bevorzugter Kristalldurchmesser ist 150 mm. Außerdem haben die SiC-Volumeneinkristalle 2, 33 insbesondere einen spezifischen elektrischen Widerstand im Bereich zwischen 12·10⁻³ Ωcm und 26·10⁻³ Qcm, vorzugsweise im Bereich zwischen 16·10⁻³ Ωcm und 24·10⁻³ Ωcm.

## Patentansprüche

1. Verfahren zur Herstellung mindestens eines SiC-Volumeneinkristalls (2; 33) mittels Sublimationszüchtung, wobei
a) vor dem Züchtungsbeginn in mindestens einem Kristallwachstumsbereich (5; 36) eines Züchtungstiegels (3; 34) mindestens ein SiC-Keimkristall (8; 37) angeordnet wird, und in einen SiC-Vorratsbereich (4; 35) des Züchtungstiegels (3; 34) SiC-Quellmaterial (6) eingebracht wird,
b) während der Züchtung mittels Sublimation des SiC-Quellmaterials (6) und mittels Transport der sublimierten gasförmigen Komponenten in den mindestens einen Kristallwachstumsbereich (5; 36) dort eine SiC-Wachstumsgasphase (9; 38) erzeugt wird, und der mindestens eine eine zentrale Mittenlängsachse (14) aufweisende SiC-Volumeneinkristall (2; 33) mittels Abscheidung aus der SiC-Wachstumsgasphase (9; 38) auf dem mindestens einen SiC-Keimkristall (8; 37) aufwächst,
wobei
c) der Züchtungstiegel (3; 34) vor dem Züchtungsbeginn mit einer rotationssymmetrischen und sich axial in Richtung der zentralen Mittenlängsachse (14) erstreckenden Isolation (10; 41) umgeben wird, die mindestens zwei Isolationsteilzylinder (19, 20; 42, 43, 44) aufweist, wobei
c1) die mindestens zwei Isolationsteilzylinder (19, 20; 42, 43, 44) konzentrisch zueinander angeordnet und ineinander gesetzt werden, und jeder der mindestens zwei Isolationsteilzylinder (19, 20; 42, 43, 44) eine in einer radialen Richtung gemessene Wandstärke (D1, D2; D3) hat,
c2) die Isolation (10; 41) fiktiv in mehrere axial in Richtung der zentralen Mittenlängsachse (14) hintereinander angeordnete Isolationsringsegmente (29) aufgeteilt wird,
c3) jedes dieser Isolationsringsegmente (29) seinerseits fiktiv in mehrere in einer tangentialen Richtung nebeneinander angeordnete Volumenelemente (31) aufgeteilt wird,
c4) jedes dieser Isolationsringsegmente (29) jeweils eine über die Wandstärken (D1, D2; D3) aller der mindestens zwei Isolationsteilzylinder (19, 20; 42, 43, 44) gemessene mittlere Isolationsringsegmentdichte (pM) aufweist,
c5) wobei sich jedes Volumenelement (31) in axialer Richtung über eine axiale Elementlänge (H), die gleich groß wie eine axiale Segmentlänge des Isolationsringsegments (29) ist und die bis zu 50 mm beträgt, in Umfangsrichtung über eine äußere tangentiale Elementlänge (L) von bis zu 50 mm und in radialer Richtung über die Addition aller Wandstärken (D1, D2; D3) der mindestens zwei Isolationsteilzylinder (19, 20; 42, 43, 44) erstreckt,
**dadurch gekennzeichnet, dass**
c6) die mindestens zwei Isolationsteilzylinder (19, 20; 42, 43, 44), die jeweils Dichteabweichungen in Teilbereichen haben, so ausgewählt und zueinander platziert werden, dass jedes Volumenelement (31) des betreffenden Isolationsringsegments (29) eine Volumenelementdichte (pV) hat, die um höchstens 10% von der mittleren Isolationsringsegmentdichte (pM) des betreffenden Isolationsringsegments (29) abweicht.

2. Verfahren nach Anspruch 1, **dadurch gekennzeichnet, dass** für die Isolation (10; 41) ein Isolationsmaterial mit einer Materialdichte zwischen 0,05 g/cm³ und 0,5 g/cm³, insbesondere zwischen 0,1 g/cm³ und 0,2 g/cm³, gewählt wird.

3. Verfahren nach Anspruch 1 oder 2, **dadurch gekennzeichnet, dass** vor Züchtungsbeginn an den mindestens zwei Isolationsteilzylindern (19, 20; 42, 43, 44; 23) eine Dichtebestimmung mittels eines röntgenographischen Verfahrens durchgeführt wird.

4. Verfahren nach einem der vorhergehenden Ansprüche, **dadurch gekennzeichnet, dass** die mindestens zwei Isolationsteilzylinder (19, 20; 42, 43, 44) so ausgewählt und zueinander platziert werden, dass jedes Volumenelement (31) des betreffenden Isolationsringsegments (29) eine Volumenelementdichte (pV) hat, die um höchstens 5% von der mittleren Isolationsringsegmentdichte (pM) des betreffenden Isolationsringsegments (29) abweicht.

5. Verfahren nach einem der vorhergehenden Ansprüche, **dadurch gekennzeichnet, dass** das jeweilige Isolationsringsegment (29) und die Volumenelemente (31) dieses Isolationsringsegments (29) so gewählt werden, dass die axiale Elementlänge (H) der Volumenelemente (31) 20 mm und die äußere tangentiale Elementlänge (L) der Volumenelemente (31) 20 mm beträgt.

6. Verfahren nach einem der vorhergehenden Ansprüche, **dadurch gekennzeichnet, dass** die mindestens zwei Isolationsteilzylinder (19, 20; 42, 43, 44) so gewählt werden, dass ihre radiale Wandstärke (D1, D2; D3) jeweils im Bereich zwischen 5 mm und 50 mm, insbesondere zwischen 10 mm und 20 mm, liegt.

7. Verfahren nach einem der vorhergehenden Ansprüche, **dadurch gekennzeichnet, dass** die mindestens zwei Isolationsteilzylinder (19, 20; 42, 43, 44) so gewählt werden, dass ein Quotient zweier der radialen Wandstärken (D1, D2; D3) im Bereich zwischen 0,5 und 2 liegt.

8. Verfahren nach einem der vorhergehenden Ansprüche, **dadurch gekennzeichnet, dass** die Isolation (10; 41) so aufgebaut wird, dass zwei zueinander benachbarte der mindestens zwei Isolationsteilzylinder (19, 20; 42, 43, 44) jeweils einen radialen Abstand im Bereich zwischen 0,1 mm und 5 mm, insbesondere zwischen 1 mm und 2 mm, aufweisen.

9. Züchtungsanordnung zur Herstellung mindestens eines SiC-Volumeneinkristalls (2; 33) mittels Sublimationszüchtung, aufweisend
a) einen Züchtungstiegel (3; 34) mit mindestens einem Kristallwachstumsbereich (5; 36), der jeweils zur Aufnahme eines SiC-Keimkristalls (8; 37) bestimmt ist, und mit einem SiC-Vorratsbereich (4; 35), der zur Aufnahme von SiC-Quellmaterial (6) bestimmt ist, und
b) eine Heizeinrichtung (12; 40) zur Erhitzung des Züchtungstiegels (3; 34), so dass während der Züchtung eine Sublimation des SiC-Quellmaterials (6), ein Transport der sublimierten gasförmigen Komponenten in den mindestens einen Kristallwachstumsbereich (5; 36) und dort eine Erzeugung einer SiC-Wachstumsgasphase (9; 38) stattfindet, wodurch der mindestens eine eine zentrale Mittenlängsachse (14) aufweisende SiC-Volumeneinkristall (2; 33) mittels Abscheidung aus der SiC-Wachstumsgasphase (9; 38) auf dem mindestens einen SiC-Keimkristall (8; 37) aufwächst,
wobei
c) der Züchtungstiegel (3; 34) von einer rotationssymmetrischen und sich axial in Richtung der zentralen Mittenlängsachse (14) erstreckenden Isolation (10; 41) umgeben ist, die mindestens zwei Isolationsteilzylinder (19, 20; 42, 43, 44) aufweist, wobei
c1) die mindestens zwei Isolationsteilzylinder (19, 20; 42, 43, 44) konzentrisch zueinander angeordnet und ineinander gesetzt sind, und jeder der mindestens zwei Isolationsteilzylinder (19, 20; 42, 43, 44) eine in einer radialen Richtung gemessene Wandstärke (D1, D2; D3) hat,
c2) die Isolation (10; 41) fiktiv in mehrere axial in Richtung der zentralen Mittenlängsachse (14) hintereinander angeordnete Isolationsringsegmente (29) aufgeteilt ist,
c3) jedes dieser Isolationsringsegmente (29) seinerseits fiktiv in mehrere in einer tangentialen Richtung nebeneinander angeordnete Volumenelemente (31) aufgeteilt ist,
c4) jedes dieser Isolationsringsegmente (29) jeweils eine über die Wandstärken (D1, D2; D3) aller der mindestens zwei Isolationsteilzylinder (19, 20; 42, 43, 44) gemessene mittlere Isolationsringsegmentdichte (pM) aufweist,
c5) wobei sich jedes Volumenelement (31) in axialer Richtung über eine axiale Elementlänge (H), die gleich groß wie eine axiale Segmentlänge des Isolationsringsegments (29) ist und die bis zu 50 mm beträgt, in Umfangsrichtung über eine äußere tangentiale Elementlänge (L) von bis zu 50 mm und in radialer Richtung über die Addition aller Wandstärken (D1, D2; D3) der mindestens zwei Isolationsteilzylinder (19, 20; 42, 43, 44) erstreckt,
**dadurch gekennzeichnet, dass**
c6) die mindestens zwei Isolationsteilzylinder (19, 20; 42, 43, 44), die jeweils Dichteabweichungen in Teilbereichen haben, so ausgewählt und zueinander platziert sind, dass jedes Volumenelement (31) des betreffenden Isolationsringsegments (29) eine Volumenelementdichte (pV) hat, die um höchstens 10% von der mittleren Isolationsringsegmentdichte (pM) des betreffenden Isolationsringsegments (29) abweicht.

10. Züchtungsanordnung nach Anspruch 9, **dadurch gekennzeichnet, dass** die Isolation (10; 41) ein Isolationsmaterial mit einer Materialdichte zwischen 0,05 g/cm³ und 0,5 g/cm³, insbesondere zwischen 0,1 g/cm³ und 0,2 g/cm³, aufweist.

11. Züchtungsanordnung nach Anspruch 9 oder 10, **dadurch gekennzeichnet, dass** die mindestens zwei Isolationsteilzylinder (19, 20; 42, 43, 44) so ausgewählt und zueinander platziert sind, dass jedes Volumenelement (31) des betreffenden Isolationsringsegments (29) eine Volumenelementdichte (pV) hat, die um höchstens 5% von der mittleren Isolationsringsegmentdichte (pM) des betreffenden Isolationsringsegments (29) abweicht.

12. Züchtungsanordnung nach einem der Ansprüche 9 bis 11, **dadurch gekennzeichnet, dass** die axiale Elementlänge (H) der Volumenelemente (31) 20 mm und die äußere tangentiale Elementlänge (L) der Volumenelemente (31) 20 mm beträgt.

13. Züchtungsanordnung nach einem der Ansprüche 9 bis 12, **dadurch gekennzeichnet, dass** die radiale Wandstärke (D1, D2; D3) jedes der mindestens zwei Isolationsteilzylinder (19, 20; 42, 43, 44) im Bereich zwischen 5 mm und 50 mm, insbesondere zwischen 10 mm und 20 mm, liegt.

14. Züchtungsanordnung nach einem der Ansprüche 9 bis 13, **dadurch gekennzeichnet, dass** ein Quotient zweier der radialen Wandstärken (D1, D2; D3) der mindestens zwei Isolationsteilzylinder (19, 20; 42, 43, 44) im Bereich zwischen 0,5 und 2 liegt.

15. Züchtungsanordnung nach einem der Ansprüche 9 bis 14, **dadurch gekennzeichnet, dass** zwei zueinander benachbarte der mindestens zwei Isolationsteilzylinder (19, 20; 42, 43, 44) jeweils einen radialen Abstand im Bereich zwischen 0,1 mm und 5 mm, insbesondere zwischen 1 mm und 2 mm, aufweisen.

## Claims

1. Method of producing at least one bulk SiC single crystal (2; 33) by means of sublimation growth, wherein
a) prior to the commencement of growing at least one SiC seed crystal (8; 37) is disposed in at least one crystal growth region (5; 36) of a growth crucible (3; 34), and SiC source material (6) is introduced into a SiC reservoir region (4; 35) of the growth crucible (3; 34),
b) during the growing an SiC growth gas phase (9; 38) is generated in the at least one crystal growth region (5; 36) by means of sublimation of the SiC source material (6) and by means of transport of the sublimed gaseous components into the at least one crystal growth region (5; 36), and the at least one bulk SiC single crystal (2; 33) having a central middle longitudinal axis (14) is grown onto the at least one SiC seed crystal (8; 37) by means of deposition from the SiC growth gas phase (9; 38),
wherein
c) the growth crucible (3; 34) prior to commencement of growing is surrounded by an insulation (10; 41) that extends in a rotationally symmetric manner and axially in the direction of the central middle longitudinal axis (14) and has at least two insulation cylinder components (19, 20; 42, 43, 44), wherein
c1) the at least two insulation cylinder components (19, 20; 42, 43, 44) are in a mutually concentric arrangement with one inside the other, and each of the at least two insulation cylinder components (19, 20; 42, 43, 44) has a wall thickness (D1, D2; D3) measured in a radial direction,
c2) the insulation (10; 41) is notionally divided into multiple insulation ring segments (29) arranged successively and axially in the direction of the central middle longitudinal axis (14),
c3) each of these insulation ring segments (29) is in turn notionally divided into multiple volume elements (31) arranged alongside one another in a tangential direction,
c4) each of these insulation ring segments (29) has an average insulation ring segment density (pM) measured over the wall thicknesses (D1, D2; D3) of all of the at least two insulation cylinder components (19, 20; 42, 43, 44),
c5) wherein every volume element (31) extends in axial direction over an axial element length (H) which is equal to an axial segment length of the insulation ring segment (29) and is up to 50 mm, in circumferential direction over an outer tangential element length (L) of up to 50 mm, and in radial direction over the addition of all wall thicknesses (D1, D2; D3) of the at least two insulation cylinder components (19, 20; 42, 43, 44),
**characterized in that**
c6) the at least two insulation cylinder components (19, 20; 42, 43, 44), each of which have variances in density in sub-regions, are selected and positioned relative to one another in such a way that every volume element (31) of the insulation ring segment (29) in question has a volume element density (pV) varying by not more than 10% from the average insulation ring segment density (pM) of the insulation ring segment (29) in question.

2. Method according to Claim 1, **characterized in that** an insulation material having a material density between 0.05 g/cm³ and 0.5 g/cm³, especially between 0.1 g/cm³ and 0.2 g/cm³, is chosen for the insulation (10; 41).

3. Method according to Claim 1 or 2, **characterized in that** prior to commencement of growing a determination of density is performed by means of an x-ray method on the at least two insulation cylinder components (19, 20; 42, 43, 44; 23).

4. Method according to any of the preceding claims, **characterized in that** the at least two insulation cylinder components (19, 20; 42, 43, 44) are selected and positioned relative to one another such that every volume element (31) of the insulation ring segment (29) in question has a volume element density (pV) varying by not more than 5% from the average insulation ring segment density (pM) of the insulation ring segment (29) in question.

5. Method according to any of the preceding claims, **characterized in that** the respective insulation ring segment (29) and the volume elements (31) of this insulation ring segment (29) are chosen such that the axial element length (H) of the volume elements (31) is 20 mm and the outer tangential element length (L) of the volume elements (31) is 20 mm.

6. Method according to any of the preceding claims, **characterized in that** the at least two insulation cylinder components (19, 20; 42, 43, 44) are chosen such that their radial wall thickness (D1, D2; D3) is in each case in the range between 5 mm and 50 mm, especially between 10 mm and 20 mm.

7. Method according to any of the preceding claims, **characterized in that** the at least two insulation cylinder components (19, 20; 42, 43, 44) are chosen such that a quotient of two of the radial wall thicknesses (D1, D2; D3) is in the range between 0.5 and 2.

8. Method according to any of the preceding claims, **characterized in that** the insulation (10; 41) is constructed in such a way that two mutually adjacent insulation cylinder components among the at least two insulation cylinder components (19, 20; 42, 43, 44) each have a radial separation in the range between 0.1 mm and 5 mm, especially between 1 mm and 2 mm.

9. Growth arrangement for production of at least one bulk SiC single crystal (2; 33) by means of sublimation growth, having
a) a growth crucible (3; 34) having at least one crystal growth region (5; 36), each intended to accommodate an SiC seed crystal (8; 37), and having an SiC reservoir region (4; 35) intended to accommodate SiC source material (6), and
b) a heating device (12; 40) for heating the growth crucible (3; 34), such that, during the growth, sublimation of the SiC source material (6), transport of the sublimed gaseous components into the at least one crystal growth region (5; 36) and generation of an SiC growth gas phase (9; 38) thereon takes place, as a result of which the at least one bulk SiC single crystal (2; 33) having a central middle longitudinal axis (14) is grown onto the at least one SiC seed crystal (8; 37) by means of deposition from the SiC growth gas phase (9; 38),
wherein
c) the growth crucible (3; 34) is surrounded by an insulation (10; 41) that extends in a rotationally symmetric manner and axially in the direction of the central middle longitudinal axis (14) and has at least two insulation cylinder components (19, 20; 42, 43, 44), wherein
c1) the at least two insulation cylinder components (19, 20; 42, 43, 44) are in a mutually concentric arrangement with one inside the other, and each of the at least two insulation cylinder components (19, 20; 42, 43, 44) has a wall thickness (D1, D2; D3) measured in a radial direction,
c2) the insulation (10; 41) is notionally divided into multiple insulation ring segments (29) arranged successively and axially in the direction of the central middle longitudinal axis (14),
c3) each of these insulation ring segments (29) is in turn notionally divided into multiple volume elements (31) arranged alongside one another in a tangential direction,
c4) each of these insulation ring segments (29) has an average insulation ring segment density (pM) measured over the wall thicknesses (D1, D2; D3) of all of the at least two insulation cylinder components (19, 20; 42, 43, 44),
c5) wherein every volume element (31) extends in axial direction over an axial element length (H) which is equal to an axial segment length of the insulation ring segment (29) and is up to 50 mm, in circumferential direction over an outer tangential element length (L) of up to 50 mm, and in radial direction over the addition of all wall thicknesses (D1, D2; D3) of the at least two insulation cylinder components (19, 20; 42, 43, 44),
**characterized in that**
c6) the at least two insulation cylinder components (19, 20; 42, 43, 44), each of which have variances in density in sub-regions, are selected and positioned relative to one another in such a way that every volume element (31) of the insulation ring segment (29) in question has a volume element density (pV) varying by not more than 10% from the average insulation ring segment density (pM) of the insulation ring segment (29) in question.

10. Growth arrangement according to Claim 9, **characterized in that** the insulation (10; 41) includes an insulation material having a material density between 0.05 g/cm³ and 0.5 g/cm³, especially between 0.1 g/cm³ and 0.2 g/cm³.

11. Growth arrangement according to Claim 9 or 10, **characterized in that** the at least two insulation cylinder components (19, 20; 42, 43, 44) are selected and positioned relative to one another such that every volume element (31) of the insulation ring segment (29) in question has a volume element density (pV) varying by not more than 5% from the average insulation ring segment density (pM) of the insulation ring segment (29) in question.

12. Growth arrangement according to any of Claims 9 to 11, **characterized in that** the axial element length (H) of the volume elements (31) is 20 mm and the outer tangential element length (L) of the volume elements (31) is 20 mm.

13. Growth arrangement according to any of Claims 9 to 12, **characterized in that** the radial wall thickness (D1, D2; D3) of each of the at least two insulation cylinder components (19, 20; 42, 43, 44) is in the range between 5 mm and 50 mm, especially between 10 mm and 20 mm.

14. Growth arrangement according to any of Claims 9 to 13, **characterized in that** a quotient of two of the radial wall thicknesses (D1, D2; D3) of the at least two insulation cylinder components (19, 20; 42, 43, 44) is in the range between 0.5 and 2.

15. Growth arrangement according to any of Claims 9 to 14, **characterized in that** two mutually adjacent insulation cylinder components among the at least two insulation cylinder components (19, 20; 42, 43, 44) each have a radial separation in the range between 0.1 mm and 5 mm, especially between 1 mm and 2 mm.

## Revendications

1. Procédé de production d'au moins un monocristal volumique de SiC (2 ; 33) par croissance par sublimation, dans lequel
a) avant le début de la croissance, au moins un cristal germe de SiC (8 ; 37) est disposé dans au moins une zone de croissance de cristal (5 ; 36) d'un creuset de croissance (3 ; 34), et un matériau source de SiC (6) est introduit dans une zone de réserve de SiC (4 ; 35) du creuset de croissance (3 ; 34),
b) pendant la croissance, au moyen de la sublimation du matériau source de SiC (6) et du transport des composants gazeux sublimés dans l'au moins une zone de croissance de cristal (5 ; 36), une phase gazeuse de croissance de SiC (9 ; 38), et ledit au moins un monocristal volumique de SiC (2 ; 33) présentant un axe longitudinal central (14) croît par dépôt à partir de la phase gazeuse de croissance de SiC (9 ; 38) sur ledit au moins un cristal germe de SiC (8 ; 37),
dans lequel
c) le creuset de croissance (3 ; 34) est entouré, avant le début de la croissance, d'une isolation (10 ; 41) à symétrie de révolution et s'étendant axialement dans la direction de l'axe longitudinal central (14), laquelle présente au moins deux sous-cylindres d'isolation (19, 20 ; 42, 43, 44), dans lequel
c1) les au moins deux sous-cylindres d'isolation (19, 20 ; 42, 43, 44) sont disposés de manière concentrique l'un par rapport à l'autre et sont placés l'un dans l'autre, et chacun des au moins deux sous-cylindres d'isolation (19, 20 ; 42, 43, 44) a une épaisseur de paroi (D1, D2 ; D3) mesurée dans une direction radiale,
c2) l'isolation (10 ; 41) est fictivement divisée en plusieurs segments annulaires d'isolation (29) disposés axialement les uns derrière les autres dans la direction de l'axe longitudinal central (14),
c3) chacun de ces segments annulaires d'isolation (29) est à son tour divisé fictivement en plusieurs éléments de volume (31) disposés côte à côte dans une direction tangentielle,
c4) chacun de ces segments annulaires d'isolation (29) présente respectivement une densité moyenne de segment annulaire d'isolation (pM) mesurée sur les épaisseurs de paroi (D1, D2 ; D3) de tous les au moins deux sous-cylindres d'isolation (19, 20 ; 42, 43, 44),
c5) chaque élément de volume (31) s'étendant dans la direction
axiale sur une longueur d'élément axiale (H) qui est égale à une longueur de segment axiale du segment annulaire d'isolation (29) et qui est de jusqu'à 50 mm, dans la direction circonférentielle sur une longueur d'élément tangentielle extérieure (L) de jusqu'à 50 mm et dans la direction radiale sur l'addition de toutes les épaisseurs de paroi (D1, D2 ; D3) des au moins deux sous-cylindres d'isolation (19, 20 ; 42, 43, 44), **caractérisé en ce que**
c6) les au moins deux sous-cylindres d'isolation (19, 20 ; 42, 43, 44), qui ont chacun des écarts de densité dans des zones partielles, sont sélectionnés et placés l'un par rapport à l'autre de telle sorte que chaque élément de volume (31) du segment annulaire d'isolation (29) concerné a une densité d'élément de volume (pV) qui s'écarte d'au plus 10 % de la densité de segment annulaire d'isolation (pM) du segment annulaire d'isolation (29) concerné.

2. Procédé selon la revendication 1, **caractérisé en ce que** l'on choisit pour l'isolation (10 ; 41) un matériau isolant ayant une densité de matériau comprise entre 0,05 g/cm³ et 0,5 g/cm³, en particulier entre 0,1 g/cm³ et 0,2 g/cm³.

3. Procédé selon la revendication 1 ou 2, **caractérisé en ce que,** avant le début de la croissance, une détermination de la densité est effectuée sur les au moins deux sous-cylindres d'isolation (19, 20 ; 42, 43, 44 ; 23) au moyen d'un procédé radiographique.

4. Procédé selon l'une quelconque des revendications précédentes, **caractérisé en ce que** les au moins deux sous-cylindres d'isolation (19, 20 ; 42, 43, 44) sont sélectionnés et placés l'un par rapport à l'autre de telle sorte que chaque élément de volume (31) du segment annulaire d'isolation (29) concerné a une densité d'élément de volume (pV) qui s'écarte d'au plus 5% de la densité moyenne de segment annulaire d'isolation (pM) du segment annulaire d'isolation (29) concerné.

5. Procédé selon l'une quelconque des revendications précédentes, **caractérisé en ce que** le segment annulaire d'isolation (29) respectif et les éléments de volume (31) de ce segment annulaire d'isolation (29) sont choisis de telle sorte que la longueur d'élément axiale (H) des éléments de volume (31) est de 20 mm et la longueur d'élément tangentielle extérieure (L) des éléments de volume (31) est de 20 mm.

6. Procédé selon l'une quelconque des revendications précédentes, **caractérisé en ce que** les au moins deux sous-cylindres d'isolation (19, 20 ; 42, 43, 44) sont choisis de telle sorte que leur épaisseur de paroi radiale (D1, D2 ; D3) soit respectivement comprise entre 5 mm et 50 mm, en particulier entre 10 mm et 20 mm.

7. Procédé selon l'une quelconque des revendications précédentes, **caractérisé en ce que** les au moins deux sous-cylindres d'isolation (19, 20 ; 42, 43, 44) sont choisis de telle sorte qu'un quotient de deux des épaisseurs de paroi radiales (D1, D2 ; D3) soit compris entre 0,5 et 2.

8. Procédé selon l'une quelconque des revendications précédentes, **caractérisé en ce que** l'isolation (10 ; 41) est construite de telle sorte que deux sous-cylindres d'isolation (19, 20 ; 42, 43, 44) voisins l'un de l'autre parmi les au moins deux sous-cylindres d'isolation présentent chacun une distance radiale dans la plage comprise entre 0,1 mm et 5 mm, en particulier entre 1 mm et 2 mm.

9. Dispositif de croissance pour la production d'au moins un monocristal volumique de SiC (2 ; 33) au moyen d'une croissance par sublimation, présentant
a) un creuset de croissance (3 ; 34) avec au moins une zone de croissance de cristal (5 ; 36), qui est destinée respectivement à recevoir un cristal germe de SiC (8 ; 37), et avec une zone de réserve de SiC (4 ; 35), qui est destinée à recevoir un matériau source de SiC (6), et
b) un dispositif de chauffage (12 ; 40) pour le chauffage du creuset de croissance (3 ; 34), de sorte que pendant la croissance, une sublimation du matériau source de SiC (6), un transport des composants gazeux sublimés dans ladite au moins une zone de croissance de cristal (5 ; 36) et qu'il s'y produit une production d'une phase gazeuse de croissance de SiC (9 ; 38), ce qui fait que le monocristal volumique de SiC (2 ; 33) présentant au moins un axe longitudinal central (14) croît par dépôt à partir de la phase gazeuse de croissance de SiC (9 ; 38) sur le cristal germe de SiC (8 ; 37) au moins présent,
dans lequel
c) le creuset de croissance (3 ; 34) est entouré d'une isolation (10 ; 41) à symétrie de révolution et s'étendant axialement dans la direction de l'axe longitudinal central (14), qui présente au moins deux sous-cylindres d'isolation (19, 20 ; 42, 43, 44), dans lequel
c1) les au moins deux sous-cylindres d'isolation (19, 20 ; 42, 43, 44) sont disposés de manière concentrique l'un par rapport à l'autre et sont placés l'un dans l'autre, et chacun des au moins deux sous-cylindres d'isolation (19, 20 ; 42, 43, 44) a une épaisseur de paroi (D1, D2 ; D3) mesurée dans une direction radiale,
c2) l'isolation (10 ; 41) est fictivement divisée en plusieurs segments annulaires d'isolation (29) disposés axialement les uns derrière les autres dans la direction de l'axe longitudinal central (14),
c3) chacun desdits segments annulaires d'isolation (29) est à son tour fictivement divisé en plusieurs éléments de volume (31) disposés côte à côte dans une direction tangentielle,
c4) chacun de ces segments annulaires d'isolation (29) présente respectivement une densité moyenne de segment annulaire d'isolation (pM) mesurée sur les épaisseurs de paroi (D1, D2 ; D3) de tous les au moins deux sous-cylindres d'isolation (19, 20 ; 42, 43, 44),
c5) chaque élément de volume (31) s'étendant dans la direction axiale sur une longueur d'élément axiale (H) qui est égale à une longueur de segment axiale du segment annulaire d'isolation (29) et qui est de jusqu'à 50 mm, dans la direction circonférentielle sur une longueur d'élément tangentielle extérieure (L) de jusqu'à 50 mm et dans la direction radiale sur l'addition de toutes les épaisseurs de paroi (D1, D2 ; D3) des au moins deux sous-cylindres d'isolation (19, 20 ; 42, 43, 44),
**caractérisé en ce que**
c6) les au moins deux sous-cylindres d'isolation (19, 20 ; 42, 43, 44), qui ont chacun des écarts de densité dans des zones partielles, sont sélectionnés et placés l'un par rapport à l'autre de telle sorte que chaque élément de volume (31) du segment annulaire d'isolation (29) concerné a une densité d'élément de volume (pV) qui s'écarte d'au plus 10 % de la densité moyenne de segment annulaire d'isolation (pM) du segment annulaire d'isolation (29) concerné.

10. Dispositif de croissance selon la revendication 9, **caractérisé en ce que** l'isolation (10 ; 41) comprend un matériau isolant ayant une densité de matériau comprise entre 0,05 g/cm³ et 0,5 g/cm³, en particulier entre 0,1 g/cm³ et 0,2 g/cm³.

11. Dispositif de croissance selon la revendication 9 ou 10, **caractérisé en ce que** les au moins deux sous-cylindres d'isolation (19, 20 ; 42, 43, 44) sont sélectionnés et placés l'un par rapport à l'autre de telle sorte que chaque élément de volume (31) du segment annulaire d'isolation (29) concerné a une densité d'élément de volume (pV) qui s'écarte d'au plus 5 % de la densité moyenne de segment annulaire d'isolation (pM) du segment annulaire d'isolation (29) concerné.

12. Dispositif de croissance selon l'une quelconque des revendications 9 à 11, **caractérisé en ce que** la longueur d'élément axiale (H) des éléments de volume (31) est de 20 mm et la longueur d'élément tangentielle extérieure (L) des éléments de volume (31) est de 20 mm.

13. Dispositif de croissance selon l'une quelconque des revendications 9 à 12, **caractérisé en ce que** l'épaisseur de paroi radiale (D1, D2 ; D3) de chacun des au moins deux sous-cylindres d'isolation (19, 20 ; 42, 43, 44) est comprise entre 5 mm et 50 mm, en particulier entre 10 mm et 20 mm.

14. Dispositif de croissance selon l'une quelconque des revendications 9 à 13, **caractérisé en ce qu'**un quotient de deux des épaisseurs de paroi radiales (D1, D2 ; D3) des au moins deux sous-cylindres d'isolation (19, 20 ; 42, 43, 44) est compris entre 0,5 et 2.

15. Dispositif de croissance selon l'une quelconque des revendications 9 à 14, **caractérisé en ce que** deux sous-cylindres d'isolation (19, 20 ; 42, 43, 44) voisins l'un de l'autre parmi les au moins deux sous-cylindres d'isolation présentent chacun une distance radiale dans la plage comprise entre 0,1 mm et 5 mm, en particulier entre 1 mm et 2 mm.
